Europäisches Patentamt

European Patent Office

Office européen des brevets

(19)

(11) Veröffentlichungsnummer: **0 152 547**
A2

## (12) EUROPÄISCHE PATENTANMELDUNG

(21) Anmeldenummer: 84113589.0

(22) Anmeldetag: 10.11.84

(51) Int. Cl.⁴: **H 03 B 5/18**

(30) Priorität: 17.02.84 DE 3405683

(43) Veröffentlichungstag der Anmeldung: 28.08.85
Patentblatt 85/35

(84) Benannte Vertragsstaaten: **DE FR GB IT SE**

(71) Anmelder: **Blaupunkt-Werke GmbH,
Robert-Bosch-Strasse 200, D-3200 Hildesheim (DE)**

(72) Erfinder: **Ohler, Michael, Dipl.-Ing., In der Dehne 4,
D-3211 Despetal (DE)**

(74) Vertreter: **Eilers, Norbert, Dipl.-Phys., Blaupunkt-Werke
GmbH Robert-Bosch-Strasse 200, D-3200 Hildesheim
(DE)**

(54) Hochfrequenz-Oszillator.

(57) Oszillatoren für sehr hohe Frequenzen etwa zum Einsatz beim Satellitenfernsehen zeichnen sich durch einen großen Schaltungsaufwand aus. Um die erforderliche große Bandbreite überstreichen zu können, werden zudem umschaltbare Oszillatoren verwendet, wobei in jeder Schaltstellung jeweils nur ein Teil der gesamten Bandbreite durchgestimmt werden kann.

Die Erfindung ermöglicht demgegenüber einen Oszillator mit einem großen Durchstimmbereich, so daß auf eine Umschaltung verzichtet werden kann. Zudem ist nur ein geringer Schaltungsaufwand erforderlich.

Zu diesem Zweck wird ein im Resonanzkreis für die Abstimmung vorgesehener Doppelvaraktor durch eine relativ kurze Streifenleitung überbrückt, welche die Funktion einer Hubdehnungsspule besitzt. Der Resonanzkreis ist an den Emitter eines Transistors angeschlossen, während die Auskopplung am Kollektor erfolgt. Maßnahmen gegen parasitäre Schwingungen sind eine Kollektorstromzuführung in Form eines bedämpften Resonanzkreises sowie ein Resonanzkreis in der Basiszuführung.

# BLAUPUNKT-WERKE GMBH

Hochfrequenz-Oszillator

Die Erfindung betrifft einen Hochfrequenz-Oszillator mit einem Transistor
und einem ein spannungsgesteuertes Element umfassenden Resonanzkreis, insbesondere spannungsgesteuerter HF-Oszillator mit Streifenleitungen für
Empfangsschaltungen beim Satellitenfernsehen.

Neben den üblichen Oszillatoren für Tuner in Fernsehgeräten gewinnen in
letzter Zeit besondere, für sehr hohe Frequenzen ausgelegte Oszillatoren
eine zunehmende Bedeutung. Vor allem im Zusammenhang mit dem Satellitenfernsehen, welches z. B. den Empfang privater oder ausländischer Programme
für Haushalte ermöglicht, wird für das einer Parabolantenne nachgeschaltete
Empfangsgerät ein Oszillator benötigt, der zum einen für hohe Frequenzen
ausgelegt ist und zum anderen einen großen Durchstimm- bzw. Frequenzbereich
erfaßt.

Unter Verwendung von Streifenleitungen, insbesondere Mikrostreifenleitungen,
bereitet es grundsätzlich keine Schwierigkeiten, einen Oszillator aufzubauen, dessen Schwingfrequenz sich im Giga-Hertz-Bereich bewegt. Bisher wurden
solche Oszillatoren vorwiegend im kommerziellen Bereich - etwa für militärische Zwecke - eingesetzt, so daß der Aufwand für den Oszillator und die
Kosten nicht so sehr im Vordergrund gestanden haben. Es werden deshalb
Oszillatoren mit aufwendigen Schaltungen in Hybrid-Technik verwendet, deren
Herstellungskosten erheblich sind.

...

0152547

Mit der Einführung des Satellitenfernsehens und einhergehend damit auch
mit der Möglichkeit des direkten Empfangs von Satellitensendungen in Einzelhaushalten muß man jedoch eine andere Bewertung zugrunde legen. Jetzt
werden die Oszillatoren nämlich auch für die Konsumer-Anwendung interessant,
und es besteht daher das Bedürfnis, die entsprechenden Oszillatoren preisgünstig auszulegen.

Es kommt aber noch ein weiterer Gesichtspunkt hinzu, der den Durchstimmbereich des Oszillators betrifft. Bei den zur Rede stehenden Frequenzen
muß nämlich ein großer Frequenzbereich erfaßt werden, und man arbeitet
deshalb bei den schon bekannten kommerziellen Geräten mit umschaltbaren
Oszillatoren. So wird beispielweise ein Frequenzbereich von 800 MHz in zwei
Bereiche zu je 400 MHz unterteilt und der Oszillator entsprechend umgeschaltet.

Übrigens ist die Umschaltung bisher so geläufig gewesen, daß man sie sogar
auf der internationalen Welt-Rundfunk-Konferenz (1974) für die Kanaleinteilung berücksichtigt und die Kanäle entsprechend eingeteilt hat.

Jedoch bedingt ein umschaltbarer Oszillator einen zusätzlichen Aufwand,
der allenfalls noch bei kommerziellen Anwendungszwecken vertretbar sein
mag.

...

0152547.

Der Erfindung liegt die Aufgabe zugrunde, einen Hochfrequenz-Oszillator der im Oberbegriff des Anspruchs 1 genannten Gattung zu schaffen, welcher preiswert mit geringem Aufwand herstellbar ist und einen großen Durchstimmbereich ohne eine Umschaltung ermöglicht.

Die Lösung dieser Aufgabe erfolgt dadurch, daß das spannungsgesteuerte Element durch eine Streifenleitung überbrückt ist, welche die Funktion einer Hubdehnungsspule besitzt.

In der konkreten Schaltungsausführung verläuft also parallel zu dem spannungsgesteuerten Element eine Leiterbahn über einer durch ein Dielektrum getrennten Massefläche. Überraschend konnte dabei festgestellt werden, daß eine solche Streifenleitung die Funktion einer Hubdehnungsspule besitzt, und dies hat zur Folge, daß der Oszillator sich durch einen großen Durchstimmbereich auszeichnet. Es ist beispielsweise ohne weiteres möglich, einen Frequenzbereich von 1,4 GHz bis 2,2 GHz zu erfassen, ohne daß eine Umschaltung des Oszillators vorgesehen werden muß. Dadurch läßt sich der eigentliche Schaltungsaufwand für den Oszillator in vorteilhafter Weise verringern.

Das spannungsgesteuerte Element des Oszillators ist in zweckmäßiger Weise durch einen als eine Baueinheit ausgebildeten Doppelvaraktor gebildet, welcher über einen Kondensator mit relativ geringer Kapazität an den Resonanzkreis angekoppelt ist. In Versuchen hat es sich gezeigt, daß dadurch der gesamte Schaltungsaufwand für den Oszillator äußerst gering gehalten

...

werden kann, was auch im Zusammenhang mit einer anderen vorteilhaften Weiterbildung zu sehen ist, welche vorsieht, daß der frequenzbestimmende Resonanzkreis an den Emitter des Transistors angeschlossen ist. Das Ausgangssignal des Oszillators kann dann am Kollektor des Transistors abgenommen werden, und dies hat den in Versuchen bestätigten Vorteil einer sehr gleichmäßigen Ausgangsleistung. Bei bekannten Oszillatoren war demgegenüber bisher über den gesamten Frequenzbereich eine schwankende Ausgangsleistung zu beobachten.

Um parasitäre Schwingungen zu vermeiden, ist gemäß einer weiteren zweckmäßigen Ausgestaltung der Erfindung eine Kollektorstromzuführung in Form eines Leitungskreises mit Serienresonanzstelle vorgesehen, die bedämpft sein kann. Aus dem gleichen Grunde befindet sich in vorteilhafter Weise in der Basiszuführung des Transistors ein Leitungskreis mit Serienresonanzstelle.

Zum besseren Verständnis wird die Erfindung nachfolgend an Hand des in der Zeichnung dargestellten Ausführungsbeispiels näher erläutert. Es zeigen:

Fig. 1     das Prinzip-Blockschaltbild einer Empfangsschaltung
           für Satellitenfernsehen, und

Fig. 2     das Schaltbild eines erfindungsgemäßen Oszillators.

...

# BLAUPUNKT-WERKE GMBH

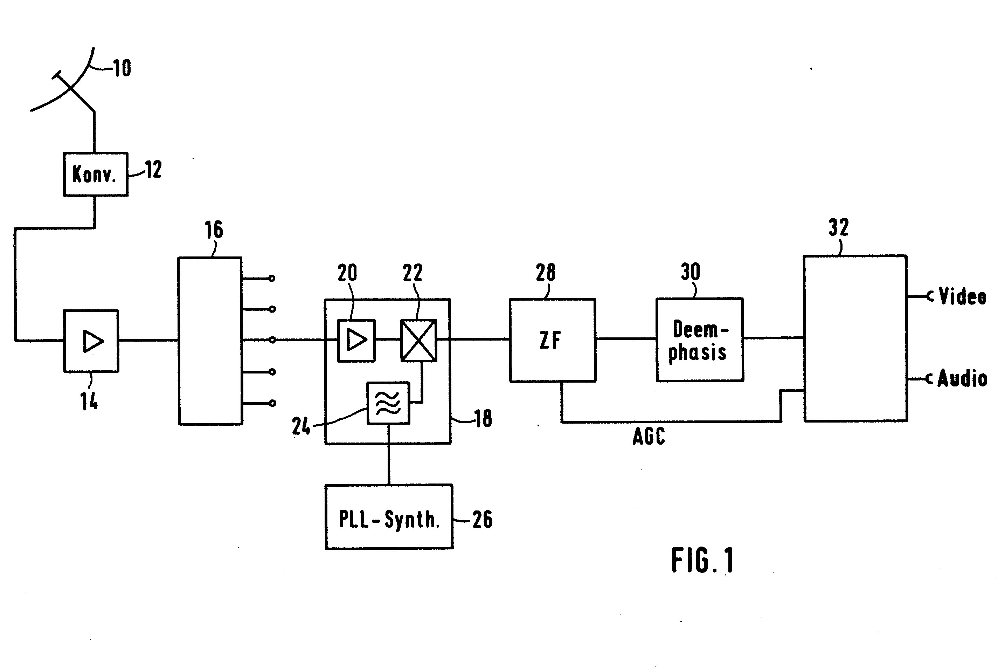

In dem Blockschaltbild gemäß Fig. 1 wird über eine Parabolantenne 10 ein Frequenzband von einem Fernsehsatelliten empfangen. An die Parabolantenne 10 schließt sich ein Konverter 12 an, dessen Ausgang eine erste Zwischenfrequenz liefert.

Über einen Verstärker 14 und einen Verteiler 16 gelangen die Signale zum Kanalwähler 18. Dieser beinhaltet neben einem Verstärker 20 und dem Mischer 22 einen HF-Oszillator 24, welcher gemäß der Erfindung aufgebaut ist, und der weiter unten noch näher erläutert wird.

Der Oszillator 24 ist mit einem Synthesizer 26 verbunden, und vom Ausgang des Mischer 22 gelangt eine feste zweite Zwischenfrequenz (480 MHz) zu einem ZF-Verstärker/Demodulator 28.

An den Ausgang von 28 schließt sich eine Deemphasis 30 an, und von dort gelangen die Signale zu einer Videobaugruppe 32. Von hier aus können Video- und Audiosignale in ein vorhandenes Kabelnetz eingespeist oder an die Audio- und Videoeingänge eines Monitors oder Fernsehgerätes geführt werden. (Der sich in Fig. 1 an den Verteiler 16 anschließende Schaltungsteil kann nämlich als integrierter Bestandteil eines Fernsehgerätes ausgebildet werden).

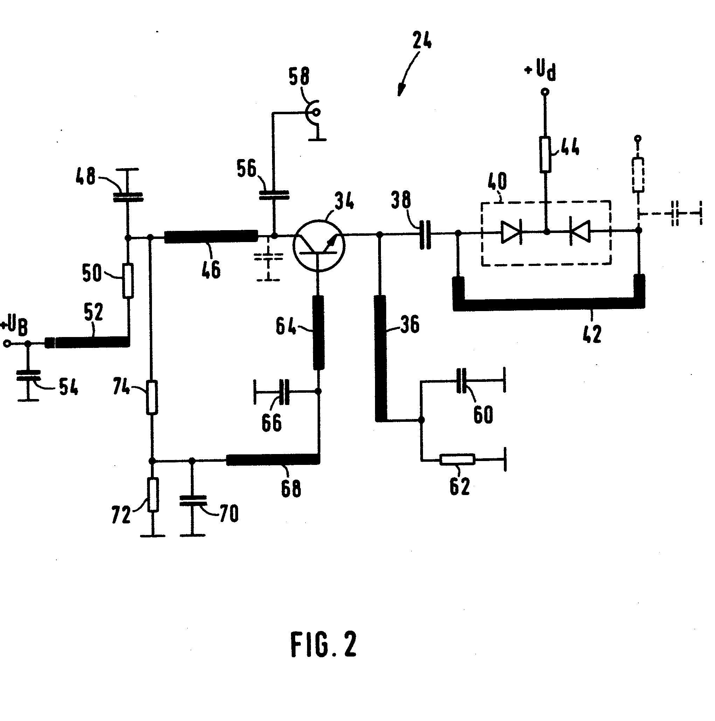

Der Oszillator 24 gemäß Fig. 2 umfaßt einen in Basisschaltung betriebenen Transistor 34 mit einer Serien-Rückkopplung durch Streifenleitungen. Der Resonanzkreis ist am Emitter des Transistors 34 angeschlossen und

...

0152547.

enthält unter anderem einen zu einer Baueinheit zusammengefaßten Doppelvaraktor 40. Dieser ist durch eine kurze Streifenleitung 42 überbrückt, welche die Funktion einer Hubdehnungsspule besitzt.

Die Ankopplung des Doppelvaraktors 40 an den Resonanzkreis erfolgt über einen Kondensator 38, der eine relativ geringe Kapazität besitzt und mit dem Emitter des Transistors 34 verbunden ist. Außerdem ist an den Emitter eine Streifenleitung 36 angeschlossen, von deren dem Emitter abgewandten Ende jeweils ein Widerstand 62 und ein Kondensator 60 nach Masse führen. Über einen Widerstand 44 wird dem Doppelvaraktor 40 eine Durchstimmspannung $U_d$ von etwa 0 bis 28 Volt zugeführt.

Übrigens ist es grundsätzlich auch möglich, anstelle des Doppelvaraktors 40 einen einzelnen Varaktor zu verwenden, jedoch hat sich gezeigt, daß der Einsatz des Doppelvaraktors 40 besonders vorteilhaft ist. Bei Anwendung eines Einzelvaraktors muß die Streifenleitung 42 aufgetrennt und mit einem Kondensator überbrückt werden.

Durch eine Kollektorstromzuführung in Form eines Leitungskreises mit Serienresonanzstelle werden parasitäre Schwingungen vermieden. An den Kollektor ist ein Netzwerk angeschlossen, das eine Streifenleitung 46 und einen Kondensator 48 umfaßt. Durch einen Widerstand 50 werden die sich bildenden Resonanzen bedämpft.

. . .

0152547

An den Widerstand 50 schließt sich eine Streifenleitung 52 an, die mit einer Betriebsspannung $U_B$ verbunden ist. Außerdem führt von der Streifenleitung 52 noch ein Kondensator 54 nach Masse.

Das dem Kollektor des Transistors 34 abgewandte Ende der Streifenleitung 46 ist über zwei Widerstände 74 und 72 ebenfalls mit Masse verbunden, und der gemeinsame Verbindungspunkt der beiden Widerstände 74 und 72 führt über eine Streifenleitung 68 sowie über eine weitere Streifenleitung 64 zur Basis des Transistors. Die beiden der Basis des Transistors 34 abgewandten Enden der Streifenleitung 64 und der Streifenleitung 68 sind über je einen Kondensator 66 bzw. 70 an Masse geschaltet.

Die Auskopplung erfolgt in Fig. 2 am Kollektor des Transistors 34, und zu diesem Zweck führt von dem Kollektor ein Kondensator 56 zu der Ausgangsklemme 58. In der gezeigten Schaltung besitzt die Auskopplung am Kollektor den Vorteil, daß über den gesamten Frequenzbereich eine gleichmäßige Ausgangsleistung entnommen werden kann.

Wie im übrigen die Zeichnung gemäß Fig. 2 schon optisch verdeutlicht, kann der erfindungsgemäße Oszillator mit einem relativ geringen Aufwand hergestellt werden, und zudem gestattet die Verwendung der Streifenleitung 42, welche den Doppelvaraktor 40 überbrückt, einen großen Durchstimmbereich, so daß auf einen umschaltbaren Oszillator verzichtet werden kann.

...

# BLAUPUNKT-WERKE GMBH

PLI-Hi Eilers/TEX2-Su — 8 — 15.2.1984
R.Nr. 1805

Einem konkreten Schaltungsbeispiel des Oszillators liegen die folgenden
Werte zugrunde:

Widerstand 44 = 10 K-Ohm

Widerstand 50 = 39 Ohm

Widerstand 62 = 470 Ohm

Widerstand 72 = 3,9 K-Ohm

Widerstand 74 = 2,2 K-Ohm

Für die verwendeten Kondensatoren ergeben sich folgende Werte:

Kondensator 38 = 3 pF

Kondensator 48 = 6 pF

Kondensator 54 = 22 nF

Kondensator 56 = 150 pF

Kondensator 60 = 6 pF

Kondensator 66 = 50 pF

Kondensator 70 = 22 nF

Bezüglich der verwendeten Mikro-Streifenleitungen werden nachfolgend
jeweils der Wellenwiderstand $Z_o$ und die "elektrische Länge" in cm angegeben (als Basismaterial ist Epoxid-Hartglasgewebe (FR 4) geeignet, und als
Transistor 34 kann der Typ BFR 92 A verwendet werden):

0152547

| | $z_o$ | cm (el.) |
|---|---|---|
| Streifenleitung 36 | 80 Ohm | 2,0 |
| Streifenleitung 42 | 80 Ohm | 1,6 |
| Streifenleitung 46 | 115 Ohm | 3,1 |
| Streifenleitung 52 | 115 Ohm | 1,5 |
| Streifenleitung 64 | 80 Ohm | 0,6 |
| Streifenleitung 68 | 100 Ohm | 2,5 |

Durch die Erfindung wird erstmals die Möglichkeit geschaffen, die gesamte Bandbreite der beim Satellitenfernsehen verwendeten ersten Zwischenfrequenz mit nur einem einzigen Oszillator 24 zu überstreichen, ohne daß Umschaltungen erforderlich sind. Gleichzeitig besitzt der Oszillator 24 einen überraschend geringen Schaltungsaufwand.

Zu erwähnen ist noch, daß an den Kollektor des Transistors 34 ein in Fig. 2 gestrichelt gezeichneter Kondensator 76 mit geringer Kapazität gegen Masse geschaltet werden kann, um die schon erwähnte Gleichmäßigkeit der Ausgangsleistung über der Abstimmung noch weiter zu verbessern.

Ferner können der Doppelvaraktor 40 und die Streifenleitung 42 galvanisch von Masse getrennt werden. In diesem Fall entfällt die von dem Punkt 82 direkt nach Masse führende Verbindung. Statt dessen werden der gestrichelt gezeichnete Widerstand 78 mit dem Anschlußpunkt 84 sowie der nach Masse führende Kondensator 80 an den Punkt 82 angeschlossen.

...

Durch diese Maßnahme ist es möglich, den zweiten Anschluß (Punkt 82) des Doppelvaraktors 40 über den Anschlußpunkt 84 zugänglich zu machen, wodurch z. B. ein Eingang für PLL-Systeme oder für eine FM-Modulation geschaffen werden kann.

Patentansprüche

1. Hochfrequenz-Oszillator mit einem Transistor und einem ein spannungsgesteuertes Element umfassenden Resonanzkreis, insbesondere spannungsgesteuerter HF-Oszillator mit Streifenleitungen für Empfangsschaltungen beim Satellitenfernsehen,

   dadurch gekennzeichnet,

   daß das spannungsgesteuerte Element (40) durch eine Streifenleitung (42) überbrückt ist.

2. Hochfrequenz-Oszillator nach Anspruch 1,

   dadurch gekennzeichnet,

   daß das spannungsgesteuerte Element ein als eine Baueinheit ausgebildeter Doppelvaraktor (40) ist, der über einen Kondensator (38) relativ geringer Kapazität an den Resonanzkreis (36, 38) angekoppelt ist.

3. Hochfrequenz-Oszillator nach Anspruch 1 oder 2,

   dadurch gekennzeichnet,

   daß der frequenzbestimmende Resonanzkreis (36, 38, 40, 42) an den Emitter des Transistors (34) angeschlossen ist.

...

4.   Hochfrequenz-Oszillator nach Anspruch 3,

     dadurch gekennzeichnet,

     daß der Ausgang (58) des Oszillators (24) mit dem Kollektor des Transistors (34) verbunden ist.

5.   Hochfrequenz-Oszillator nach einem der vorhergehenden Ansprüche 1 bis 4,

     dadurch gekennzeichnet,

     daß die Stromzuführung für den Kollektor des Transistors (34) über einen Leitungskreis mit Serienresonanz (46, 48) erfolgt.

6.   Hochfrequenz-Oszillator nach Anspruch 5,

     dadurch gekennzeichnet,

     daß der Leitungskreis (46, 48 ) bedämpft (50, 52) ist.

7.   Hochfrequenz-Oszillator nach einem der vorhergehenden Ansprüche 1 bis 6,

     dadurch gekennzeichnet,

     daß in der Basiszuführung des Transistors (34) ein Leitungskreis (64, 66) mit Serienresonanz angeordnet ist.

BLAUPUNKT-WERKE GMBH

                                                           ...

8.  Hochfrequenz-Oszillator nach einem der vorhergehenden Ansprüche 1 bis 6,

dadurch gekennzeichnet,

daß die an die Basis und an den Emitter des Transistors (34) angeschlossenen Streifenleitungen (64, 36) räumlich eng benachbart angeordnet sind, um eine Verkopplung zu erreichen.


9.  Hochfrequenz-Oszillator nach einem der vorhergehenden Ansprüche 1 bis 8,

dadurch gekennzeichnet,

daß vom Kollektor des Transistors (34) ein Kondensator (76) geringer Kapazität nach Masse geschaltet ist.


10.  Hochfrequenz-Oszillator nach einem der vorhergehenden Ansprüche 1 bis 9,

dadurch gekennzeichnet,

daß der Doppelvaraktor (40) und die den Doppelvaraktor (40) überbrückende Streifenleitung (42) galvanisch (78) von Masse getrennt

sind.

FIG.1

FIG. 2